Europäisches Patentamt

European Patent Office

Office européen des brevets

(11) Veröffentlichungsnummer: **0 481 096 A1**

# (12) EUROPÄISCHE PATENTANMELDUNG

(21) Anmeldenummer: **90116905.2**

(22) Anmeldetag: **03.09.90**

(51) Int. Cl.5: **G01R 19/252**, H03M 1/60, H03K 7/06, H02P 7/00

(43) Veröffentlichungstag der Anmeldung:
**22.04.92 Patentblatt 92/17**

(84) Benannte Vertragsstaaten:
**CH DE ES FR GB IT LI SE**

(71) Anmelder: **SIEMENS AKTIENGESELLSCHAFT**
**Wittelsbacherplatz 2**
**W-8000 München 2(DE)**

(72) Erfinder: **Hartwig, Hagen, Dipl.-Ing.**
**Paul-Gossen-Strasse 34**
**W-8520 Erlangen(DE)**
Erfinder: **Schwesig, Günter, Dipl.-Ing.**
**Lange Zeile 84**
**W-8520 Erlangen(DE)**

(54) **Verfahren zur Bestimmung der Frequenzverstärkung eines Spannung-Frequenz-Wandlers.**

(57) Mit dem Verfahren zur Bestimmung der Frequenzverstärkung ($V_f$) eines Spannungs-Frequenz-Wandlers (UF) läßt sich ein zeitlich konstanter Fehler, der beispielsweise durch analoge Bauteile (R,C) verursacht sein kann, kompensieren. Die Steuerung (R) eines elektrischen Systems (ES) sorgt dafür, daß die von der Reaktion des elektrischen Systems (ES) abgeleitete Eingangsspannung ($U_E$) des Spannungs-Frequenz-Wandlers (UF) Null ist und bestimmt dabei aus dessen Ausgangssignal (P) die zur Berechnung der Frequenzverstärkung $V_f$ benötigte Mittenfrequenz $f_0$.

FIG 1

Die Erfindung bezieht sich auf ein Verfahren zur Kompensation eines zeitlich konstanten Fehlers eines Spannungs-Frequenz-Wandlers.

Die Wandlung eines kontinuierlichen Signals in ein diskontinuierliches Signal bringt für eine Reihe von Anwendungen Vorteile mit sich. Deshalb werden Spannungs-Frequenz-Wandler in den verschiedensten Gebieten der Elektrotechnik und Elektronik verwendet. Beispielsweise lassen sich bei der Regelung von Elektromotoren die Strom- bzw. Spannungsistwerte durch Wandlung in eine dem Strom- bzw. Spannungsistwert proportionale Folge von Impulsen leicht in ein digitales Regelungskonzept integrieren.

Zur digitalen, rechnergesteuerten Regelung eines elektrischen Systems, beispielsweise eines Elektromotors, ist es vorteilhaft, das kontinuierliche Spannungs- bzw. Stromistwertsignal bereits am Ort seiner Erfassung zu digitalisieren und beispielsweise in Form von Impulsen unterschiedlicher Impuls-Folgefrequenz zu übertragen. Selbst bei einer hauptsächlich analogen Regelung kann es wegen der hohen Störsicherheit von Vorteil sein, zunächst digitale Signale für die Signalübertragung zu verwenden und diese anschließend wieder in ein kontinuierliches Signal zu transformieren.

Wegen der in vielen Anwendungsfällen geforderten Kleinheit der Abmessungen bei äußerst schneller und hochgenauer Digitalisierung eines analogen Eingangssignals sowie bei großem Frequenzhub mit möglichst geringen Kosten, kann nicht immer auf herkömmliche, auf dem Markt erhältliche Spannungs-Frequenz-Wandler zurückgegriffen werden.

In der älteren internationalen Anmeldung mit dem Aktenzeichen PCT/DE 89/00197 wurde bereits ein Verfahren zur Spannungs-Frequenz-Wandlung vorgeschlagen mit dem ein schneller und hochgenauer Spannungs-Frequenz-Wandler mit großem Frequenzhub realisiert werden kann. Dabei wird ein herkömmlicher, integrierender spannungsgesteuerter Oszillator verwendet, der durch eine präzise Regelung ein hochgenaues Puls-Pausen-Signal abgibt. Für diese Regelung wird das Ausgangssignal des spannungsgesteuerten Oszillators im wesentlichen über ein quarzgetaktetes Präzisionsmonoflop, einen Präzisionsschalter und einen Tiefpaß in eine Gleichspannung zurückverwandelt, mit der Eingangsspannung des spannungsgesteuerten Oszillators verglichen und zur Regelung desselben herangezogen. Dabei hat das quarzgesteuerte Präzisionsmonoflop die Aufgabe, zu jedem Impuls des Ausgangssignals des spannungsgesteuerten Oszillators einen Impuls mit konstanter Impulsbreite zu erzeugen. Die Genauigkeit der Regelung hängt wesentlich von der Qualität der Präzisionsimpulse ab.

Die Verwendung des Quarzoszillators im Regelkreis des spannungsgesteuerten Oszillators garantiert zwar eine hohe Genauigkeit der Präzisionsimpulse und damit des Ausgangssignals des spannungsgesteuerten Oszillators, schlägt sich aber erheblich in den Gesamtkosten einer Einrichtung zur Durchführung des Verfahrens nieder. Der Zeittakt für die Erzeugung der Präzisionsimpulse läßt sich aber auch in bekannter Weise mit passiven Bauteilen, beispielsweise mit RC-Gliedern oder Schwingkreisen etc., erzeugen, jedoch beeinträchtigt die geringere Genauigkeit von passiven Bauelementen auch die Genauigkeit eines mit diesen Bauteilen erzeugten Zeittaktes, verglichen mit der Genauigkeit des Zeittaktes eines Quarzoszillators. Es hat sich aber gezeigt, daß der wesentliche Fehler der bei einer Zeittaktgenerierung mit passiven Bauteilen bei der Regelung eines spannungsgesteuerten Oszillators auftritt, zeitlich konstant ist.

Es ist deshalb Aufgabe der Erfindung, ein Verfahren zur Bestimmung der Frequenzverstärkung eines Spannungs-Frequenz-Wandlers zu schaffen, wobei auf kostenintensive Bauteile weitgehend verzichtet werden kann und wobei zeitlich konstante Fehler kompensierbar sind.

Diese Aufgabe wird durch ein Verfahren zur Bestimmung der Frequenzverstärkung eines Spannungs-Frequenz-Wandlers mit folgenden Merkmalen gelöst:

a) von der Reaktion eines elektrischen Systems auf Steuersignale eines Rechners wird eine Spannung als Eingangsspannung des Spannungs-Frequenz-Wandlers abgeleitet,

b) die Eingangsspannung wird durch den Spannungs-Frequenz-Wandler in ein Frequenzsignal gewandelt, dessen Frequenz proportional zur Eingangsspannung ist,

c) das elektrische System wird durch den Rechner so beeinflußt, daß die Eingangsspannung des Spannungs-Frequenz-Wandlers gleich Null ist, wobei

d) der Rechner die Frequenz des Frequenzsignals als Mittenfrequenz bestimmt und damit die Verstärkung des Spannungs-Frequenz-Wandlers aus dem Verhältnis von doppelter Mittenfrequenz, multipliziert mit der inneren Verstärkung des Spannungs-Frequenz-Wandlers zur Referenzspannung des Spannungs-Frequenz-Wandlers, berechnet.

Ein vorteilhafter Regelkreis zur Regelung eines spannungsgesteuerten Oszillators besteht aus:

a) Einem Frequenzteiler, der das Ausgangssignal des spannungsgesteuerten Oszillators in einem vorgebbaren Verhältnis teilt,

b) einem bistabilen Schalter, der zu jedem Impuls des Ausgangssignals des Frequenzteilers einen Impuls mit konstanter Impulsbreite erzeugt, wobei die Impulsdauer aus einem RC-Glied abgeleitet wird,

c) einem Präzisionsschalter, der jeden Impuls konstanter Impulsbreite als Impuls mit konstantem Flächeninhalt an seinen Ausgang durchschaltet,

d) einem Tiefpaß, der die Impulse mit konstantem Flächeninhalt in eine Gleichspannung zurückwandelt,

e) einem Vergleicher, der aus der Gleichspannung am Ausgang des Tiefpasses und aus der Eingangsspannung des spannungsgesteuerten Oszillators eine Differenzspannung bildet,

f) einem Regler, der die Differenzspannung regelt und dessen Ausgangssignal dem spannungsgesteuerten Oszillator zugeführt wird.

Ein Ausführungsbeispiel der Erfindung ist in der Zeichnung dargestellt und wird im folgenden näher erläutert. Dabei zeigen

FIG 1     ein Blockschaltbild eines rechnergesteuerten elektrischen Systems mit einem Spannungs-Frequenz-Wandler,

FIG 2     ein Blockschaltbild eines Spannungs-Frequenz-Wandlers,

FIG 3     ein mit einem RC-Glied getaktetes Monoflop.

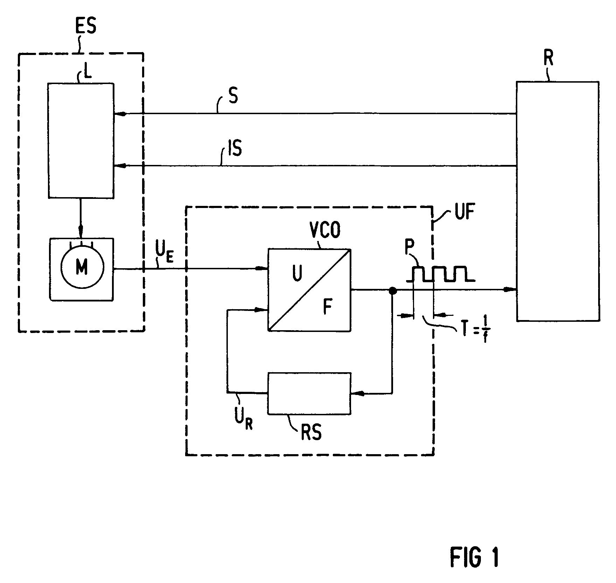

In FIG 1 ist ein Blockschaltbild eines rechnergesteuerten elektrischen Systems ES mit einem Spannungs-Frequenz-Wandler UF dargestellt. Das elektrische System ES ist gestrichelt gezeichnet und enthält im Ausführungsbeispiel einen Leistungsteil L, über den ein Motor M angesteuert wird. Der Leistungsteil L des elektrischen Systems ES ist über Steuerleitungen S mit einem Rechner R verbunden. Außerdem verfügt der Rechner noch über eine weitere Verbindung mit dem elektrischen System ES, über das ein Impulssperrsignal IS an den Leistungsteil L gegeben werden kann.

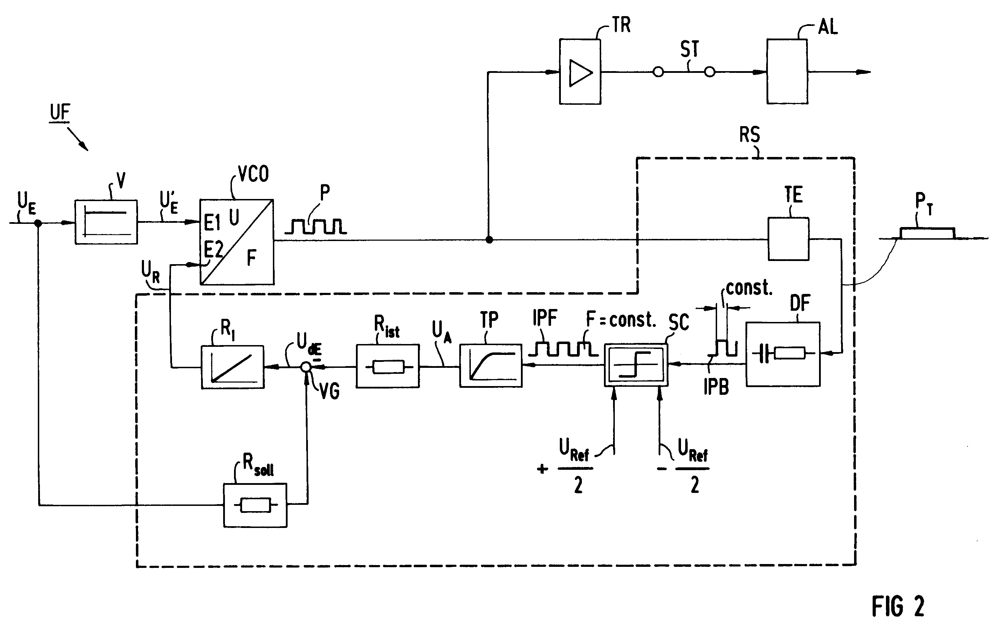

In Signalflußrichtung vom elektrischen System ES zum Rechner R liegt ein Spannungs-Frequenz-Wandler UF (gestrichelt gezeichnet), der über einen spannungsgesteuerten Oszillator VCO und eine Regelstrecke RS zur Regelung des spannungsgesteuerten Oszillators VCO verfügt. Ein Ausführungsbeispiel der Regelstrecke RS ist unten anhand der FIG 2 näher beschrieben.

Der Rechner R regelt das elektrische System ES, indem er Steuersignale über die Steuerleitungen S an den Leistungsteil L weitergibt, der die Steuersignale beispielsweise über einen nicht dargestellten Pulsbreitenmodulator aufbereitet und den Motor M entsprechend ansteuert. Die tatsächlichen Spannungsistwerte des Motors M sollen dem Rechner R in digitaler Form zur Verfügung gestellt werden, damit dieser den zur Regelung notwendigen Soll-Istwert-Vergleichvornehmen kann. Aus übertragungstechnischen Gründen, vor allem aber wegen der hohen Störsicherheit digitaler Signale, wird der Spannungsistwert möglichst nahe am Meßort, d.h. möglichst im Motor abgegriffen und über den Spannungs-Frequenz-Wandler UF in ein Frequenzsignal, das ein Pulsfolge-Signal sein kann, umgewandelt. Entgegen der schematischen Darstellung der FIG 1, bei der der Spannungs-Frequenz-Wandler UF in der Mitte zwischen dem elektrischen System ES und dem Rechner R angeordnet ist, würde also bei einem realen System der Spannungs-Frequenz-Wandler UF nahe am Meßort des Spannungsistwertes, d.h. in den meisten Fällen im Gehäuse des Motors M untergebracht sein.

Der im Motor M abgegriffene Spannungsistwert wird dem spannungsgesteuerten Oszillator VCO als Eingangsspannung $U_E$ zugeführt. Da für eine hochgenaue Regelung das Ausgangssignal P des spannungsgesteuerten Oszillators VCO zu ungenau ist, wird es über die Regelstrecke RS in eine Gleichspannung $U_R$ zurückgewandelt und dem spannungsgesteuerten Oszillator VCO zur Regelung aufgeschaltet. Der Rechner R erhält damit vom Spannungs-Frequenz-Wandler UF ein präzises Pulsfolge-Signal P, dessen Frequenz der Eingangsspannung $U_E$, also dem am Motor abgegriffenen Spannungsistwert proportional ist. Im Rechner R wird dann ein Vergleich zwischen den als Sollwerten vorgegebenen Steuersignalen und den vom Spannungs-Frequenz-Wandlerenthaltenen Istwerten durchgeführt und gegebenenfalls eine Korrektur der Steuersignale eingeleitet.

Da die Regelstrecke RS jedoch so aufgebaut ist, daß bei der Rückwandlung des Pulsfolge-Signals P in eine Gleichspannung $U_R$ ein zeitlich konstanter Fehler auftritt, wird sich dieser auch auf das Pulsfolge-Signal P auswirken. Der Rechner R muß also zunächst feststellen, welcher Frequenz f des Pulsfolge-Signals welche Eingangsspannung $U_E$ entspricht, d.h. der Rechner muß zunächst die Frequenzverstärkung $V_f$ des Spannungs-Frequenz-Wandlers kennen.

Für das Verständnis der Ermittlung der Frequenzverstärkung ist die Kenntnis der Funktionsweise der Regelstrecke RS hilfreich, die im folgenden anhand der FIG 2 beschrieben wird.

Das Blockschaltbild gemäß FIG 2 zeigt einen Spannungs-Frequenz-Wandler UF mit einer Regelstrecke RS (gestrichelt umrandet). Er besteht aus einem Verstärker V zur Pegelanpassung der Eingangsspannung $U_E$. Die Ausgangsspannung $U_E'$ des Verstärkers V wird auf einen ersten Eingang E1 eines spannungsgesteuerten Oszillators VCO geführt. Der integrierende spannungsgesteuerte Oszillator VCO liefert Einzelimpulse P, deren Häufigkeit proportional zur Höhe der Eingangsspannung $U_E$ ist. Als integrierender spannungsgesteuerter Oszillator VCO (Voltage Controlled Oszillator) kann beispielsweise ein emittergekoppelter Multivibrator, der unter der Bezeichnung LS 624 im Handel erhältlich ist, verwendet werden. Ein solcher spannungsgesteuerter Oszillator VCO zeichnet sich durch einen großen Frequenzbereich (ca. 2 bis 42 MHz) aus. Jedoch muß für diesen großen Frequenzhub eine geringere Genauigkeit des Ausgangssignals P in Kauf genommen werden.

Wegen der Ungenauigkeit des spannungsgesteuerten Oszillators wird dessen Ausgangssignal P über eine Regelstrecke RS in eine Gleichspannung $U_A$ zurückgewandelt. Dazu wird das Pulsfolge-Signal P über einen Frequenzteiler TE, einen bistabilen Schalter DF (D-Flip-Flop) einen Präzisionsschalter SC und einen Tiefpaß TP geführt.

Durch den Frequenzteiler wird die Frequenz des Pulsfolge-Signals P am Ausgang F des VCO reduziert. Bei einer Frequenz des Pulsfolge-Signals P von 10 MHz und einem Teilverhältnis des Frequenzteilers TE von 64 : 1 liegt die Frequenz des Teilerausgangssignals bei ca. 150 kHz. Es werden also Impulse $P_T$ mit längerer Impulsdauer, verglichen mit den Impulsen P des spannungsgesteuerten Oszillators VCO, erzielt. Die durch die Ein- und Ausschaltflanken der Impulse bedingten Fehler bleiben jedoch gleich, so daß die Fehler der Impulse $P_T$ des Frequenzteilers TE bezogen auf die längere Impulsdauer minimiert werden.

Das D-Flip-Flop DF hat die Aufgabe, zu jedem Impuls $P_T$ des Ausgangssignals des Frequenzteilers TE einen Präzisionsimpuls IPB mit konstanter Pulsbreite zu erzeugen. Sobald am Eingang des D-Flip-Flops DF ein Signal logisch "1" anliegt, also bei einem ankommenden Impuls $P_T$, gibt das D-Flip-Flop DF während einer vorgebbaren Zeitdauer ein Signal logisch "1" an seinem Ausgang ab.

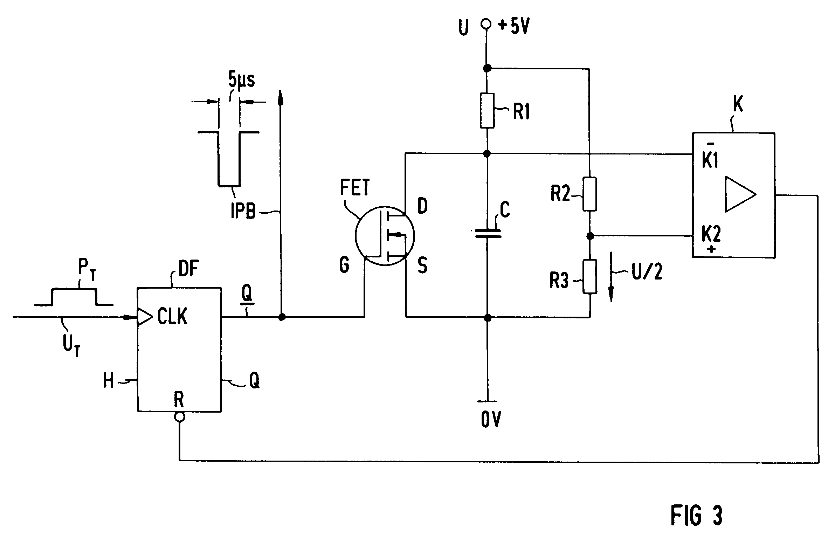

Die Zeit in der der Ausgang des D-Flip-Flops gesetzt wird, wird von der Zeitkonstanten eines RC-Gliedes abgeleitet. Eine für diesen Zweck vorteilhafte Ausführungsform wird unten anhand der FIG 3 näher beschrieben.

Der Präzisionsschalter SC erzeugt aus den vom D-Flip-Flop DF erzeugten Präzisionsimpulsen mit konstanter Pulsbreite IPB Präzisionsimpulse mit konstantem Flächeninhalt IPF, indem er die Präzisionsimpulse IPB mit konstanter Spannungsamplitude an seinen Ausgang durchschaltet. Über den Tiefpaß TP werden nun die Präzisionsimpulse IPF in eine Gleichspannung $U_A$ umgewandelt. Diese Gleichspannung $U_A$ wird am Vergleicher VG von der Eingangsspannung $U_E$ subtrahiert und die resultierende Differenzspannung $U_{dE}$ wird über einen Regler $R_I$ dem spannungsgesteuerten Oszillator VCO als Regelspannung $U_R$ aufgeschaltet.

Durch die Widerstände $R_{ist}$ und $R_{soll}$ wird die interne Verstärkung $V_U$ des Spannungs-Frequenz-Wandlers UF vorgegeben. Am Ausgang des VCO ist damit ein geregeltes Pulsfolge-Signal P abgreifbar, dessen Frequenz proportional zur Höhe der Eingangsspannung $U_E$ ist. Dieses Ausgangssignal P kann nun über eine Treiberstufe TR und eine Übertragungsstrecke ST an eine Auswertelogik AL gegeben werden, in der eine der Eingangsspannung $U_E$ proportionale Größe für die weitere Verarbeitung durch den Rechner R (FIG 1) gebildet wird. Die weitere Verarbeitung der Impulsfolgefrequenz kann dabei variieren in Bezug auf die Wahl der Abtastzeitpunkte und verschiedene Arten der Mittelwertbildung.

Die Erzeugung der Präzisionsimpulse IPB mit konstanter Pulsbreite durch das D-Flip-Flop wird im folgenden anhand der FIG 3 beschrieben.

FIG 3 zeigt ein D-Flip-Flop DF als bistabilen Schalter. Die Taktzeit des D-Flip-Flops DF wird von einem RC-Glied, das aus dem Widerstand R1 und dem Kondensator C besteht abgeleitet. Auf den Takteingang CLK des D-Flip-Flops DF wird das Ausgangssignal $P_T$ des Frequenzteilers TE (FIG 2) gegeben. Am Ausgang $\overline{Q}$ (der Unterstrich bedeutet den negierten Ausgang, wobei es dem Fachmann überlassen bleibt, welchen Ausgang er verwenden will) des D-Flip-Flops DF sind die Präzisionsimpulse IPB mit konstanter Pulsbreite abgreifbar. Zur Erzeugung der konstanten Impulsbreite ist der Ausgang $\overline{Q}$ des D-Flip-Flops mit einem Feldeffekttransistor FET verbunden. Parallel zu den Drain D und Source S Anschlüssen des Feldeffekttransistors FET liegt der Kondensator C, der über den Widerstand R1 mit einer Spannung U geladen wird. Ebenfalls mit dem Drain D Anschluß des Feldeffekttransistors FET ist ein erster Eingang K1 eines Komparators K verbunden. Ein zweiter Eingang K2 des Komparators K liegt am Mittenabgriff eines Spannungsteilers aus den Widerständen R2 und R3, der ebenfalls von der Spannung U versorgt wird. Der Ausgang des Komparators K ist mit dem negierenden Reset-Eingang R des D-Flip-Flops DF verbunden. Bedingt durch den Spannungsteiler liegt am Eingang K2 des Komparators K eine konstante Spannung von U/2 an. Befindet sich der Kondensator C im ungeladenen Zustand, so liegen am Eingang K1 des Komparators K 0 V an.

Wird durch einen ankommenden Impuls $P_T$ der Takteingang des D-Flip-Flops DF auf "high"-Pegel gesetzt, so liegt am Ausgang $\overline{Q}$ und damit auch am Gate G des Feldeffekttransistors FET ein Signal logisch "0" an. Der Feldeffekttransistors FET befindet sich damit im Sperrzustand, so daß der Kondensator C über den Widerstand R1 aufgeladen wird. Mit zunehmender Aufladung des Kondensators C steigt die Spannung am Eingang K1 des Komparators K an. Sobald diese Spannung ebenfalls den Wert U/2 erreicht, wird das Ausgangssignal des Komparators K invertiert und damit das D-Flip-Flop DF über seinen Reset-Eingang R zurückgesetzt. Der Ausgang $\overline{Q}$ des D-Flip-Flops DF und das Gate G des Feldeffekttransistors FET werden auf "high"-Pegel gesetzt wodurch der Drain-Source-Kanal D-S niederohmig wird, so daß der Kondensator C sich über den durchgeschalteten Feldeffekttransistor FET entlädt. Damit sind die Spannung am Eingang K1 des Komparators K wieder unter den Wert U/2 so daß das Ausgangssignal des Komparators und damit das Signal am Reset-Eingang R des D-Flip-Flops wieder invertiert wird und der Vorgang von vorne beginnt.

Durch dieses Wechselspiel zwischen Laden und Entladen des Kondensators C in Verbindung mit dem Komparator K, können am Ausgang $\overline{Q}$ (oder wahlweise am Ausgang Q) Impulse IPB mit konstanter Impulsbreite abgegriffen werden. Für die Genauigkeit der Schaltung sind im wesentlichen der Kondensator C und die Widerstände R1 bis R3 verantwortlich. Bei entsprechender Wahl der Bauteile ist ein Driftfehler der Schaltung über einen Temperaturbereich von 50° K von einem Promill erreichbar. Der Temperaturkoeffizient von Widerstand und Kondensator sollte nicht größer sein als 15ppm/K (part per million pro Kelvin). Der Driftfehler ist damit tolerierbar, im Gegensatz zum zeitlich konstanten Fehler, der im wesentlichen durch herstellungstechnische Mängel des Kondensators C bedingt ist und bis zu 5 %. betragen kann.

Wegen dieses zeitlich konstanten Fehlers kann die Frequenzverstärkung $V_f$ für einen jeweiligen Spannungs-Frequenz-Wandlersnicht fest vorgegeben werden. Sie wird daher durch den Rechner auf der Basis der folgenden Beziehungen bestimmt.

Die Frequenzverstärkung $V_f$ ist das Verhältnis von Ausgangsfrequenz delta $f_A$ zur Eingangsspannung delta $U_E$.

$$V_f = \text{delta } f_A/\text{delta } U_E = \text{delta } f_{max}/\text{delta } U_{Emax} \quad (1)$$

Die interne Verstärkung $V_U$ des Spannungs-Frequenz-Wandlers ist konstant und durch die Widerstände $R_{ist}$ und $R_{soll}$ genau festgelegt. Sie kann dem Rechner R (FIG 1) als konstanter Wert fest vorgegeben werden.

$$V_U = \text{delta } U_A/\text{delta } U_E = R_{ist}/R_{soll} = \text{const.} \quad (2)$$

Aus Gleichung (2) läßt sich die maximale Eingangsspannung $U_{Emax}$ berechnen

$$\text{delta } U_{Emax} = \text{delta } U_{Amax}/V_U \quad (3)$$

$$\text{mit delta } U_{Amax} = U_{Ref} \quad (4)$$

Mit Gleichung (3) läßt sich die Eingangsspannung $U_E$ aus Gleichung (1) ersetzen. Zur Bestimmung der Frequenzverstärkung $V_f$ muß noch die Maximalfrequenz delta $f_{max}$ gefunden werden. Da die Maximalfrequenz delta $f_{max}$ gleich der doppelten Mittenfrequenz $f_0$ ist, läßt sich die Frequenzverstärkung $V_f$ nach Gleichung (5) bestimmen:

$$V_f = 2f_0 . V_U/U_{Ref} \quad (5)$$

Der Rechner muß also zunächst die Mittenfrequenz $f_0$ bestimmen um sich daraus die Frequenzverstärkung $V_f$ berechnen zu können.

Die Bestimmung der Mittenfrequenz $f_0$ wird im folgenden wieder anhand der FIG 1 erläutert. Wie bereits in der Beschreibung zur FIG 1 erläutert wurde, erhält der Rechner vom Spannungs-Frequenz-Wandler UF das Pulsfolge-Signal P. Durch die Vorgabe bestimmter Steuersignale über seine Steuerleitungen S kann die Eingangsspannung $U_E$ des Spannungs-Frequenz-Wandlers UF vom Rechner direkt beeinflußt werden.

Da der Spannungs-Frequenz-Wandler UF so ausgelegt ist, daß seine Ausgangsfrequenz bei einer Eingangsspannung von $U_E = 0$ gleich der Mittenfrequenz $f_0$ ist, muß durch den Rechner R lediglich sichergestellt werden, daß die Reaktion des elektrischen Systems ES gleich Null ist. Dies könnte im Ausführungsbeispiel gemäß FIG 1 dadurch geschehen, daß über die Steuerleitungen S keine Signale an das elektrische System ES gegeben werden. Da der Leistungsteil L des elektrischen Systems ES einen Impulsbreitenmodulator besitzt, läßt sich eine solche "Null"-Reaktion des elektrischen Systems ES auch über ein zusätzliches Impulssperrsignal IS erreichen.

Nachdem die "Null"-Reaktion des elektrischen Systems sichergestellt ist, zählt der Rechner R die Impulse des Ausgangssignals P des Spannungs-Frequenz-Wandlers in einer vorgegebenen Zeitspanne und bestimmt daraus die Frequenz des Ausgangssignals P als Mittenfrequenz $f_0$.

Für die digitale Auswertung werden die Impulse P des Ausgangssignals des spannungsgesteuerten Oszillators VCO in einem bestimmten Zeitintervall gezählt. Dabei ist es besonders vorteilhaft, die Impulse in einem vorgegebenen Zeitintervall zu zählen und diese Zählung in einem kürzeren Zeitintervall periodisch zu wiederholen. Diese Auswertung kann als "gleitendes Fenster" bezeichnet werden. Beispielsweise könnte die Anzahl der Impulse P während eines Zeitraums von T = 100 msec. gezählt werden, wobei die Zählung jeweils periodisch werden, wobei die Zählung jeweils periodisch im Abstand von 5 msec. durchgeführt wird.

Die Übertragung einer hohen Pulsfolgefrequenz (beispielsweise 40 MHz) über die Treiberstufe TR und die Übertragungsstrecke ST an die Auswertelogik AL, ist für die digitale Auswertung unkritisch, da an die Impulsform der Impulse P nur geringe Ansprüche gestellt werden, so daß die Qualität des Verfahrens durch eine "Verschleifung" der Impulse P nicht beeinträchtigt wird, solange die Impulse P von der Auswertelogik AL gerade noch erkannt werden können. Falls tatsächlich ein Impuls P nicht mehr erkannt werden sollte, entsteht kein bleibender Fehler, da lediglich die Genauigkeit einer Zählung während einer Zeiteinheit beeinflußt wird. Das Verfahren weist demnach eine hohe Störsicherheit auf.

**Patentansprüche**

1. Verfahren zur Bestimmung der Frequenzverstärkung eines Spannungs-Frequenz-Wandlers (UF) mit folgenden Merkmalen:

   a) Von der Reaktion eines elektrischen Systems (ES) auf Steuersignale (S) eines Rechners (R) wird eine Spannung als Eingangsspannung ($U_E$) des Spannungs-Frequenz-Wandlers (UF) abgeleitet,

   b) die Eingangsspannung ($U_E$) wird durch den Spannungs-Frequenz-Wandler (UF) in ein Pulsfolge-Signal (P) gewandelt, dessen Frequenz proportional zur Eingangsspannung ($U_E$) ist,

   c) das elektrische System (ES) wird durch den Rechner (R) so beeinflußt, daß die Eingangsspannung ($U_E$) des Spannungs-Frequenz-Wandlers (UF) gleich Null ist, wobei

   d) der Rechner (R) die Frequenz (f) des Frequenzsignals (P) als Mittenfrequenz ($f_0$) bestimmt und damit die Verstärkung ($V_f$) des Spannungs-Frequenz-Wandlers (UF) aus dem Verhältnis von doppelter Mittenfrequenz ($f_0$), multipliziert mit der inneren Verstärkung ($V_U$) des Spannungs-Frequenz-Wandlers (UF) zur Referenzspannung ($U_A$) des Spannungs-Frequenz-Wandlers, berechnet.

2. Regelkreis zur Regelung eines integrierenden spannungsgesteuerten Oszillators (VCO) bestehend aus:

   a) Einem Frequenzteiler (TE), der das Ausgangssignal (P) des spannungsgesteuerten Oszillators (VCO) in einem vorgebbaren Verhältnis teilt,

   b) einem bistabilen Schalter (DF), der zu jedem Impuls des Ausgangssignals (P) des Frequenzteilers einen Impuls mit konstanter Impulsbreite (IPB) erzeugt, wobei die Impulsdauer aus einem RC-Glied abgeleitet wird,

   c) einem Präzisionsschalter (SC), der jeden Impuls mit konstanter Impulsbreite (IPB) als Impuls mit konstantem Flächeninhalt (IPF) an seinen Ausgang durchschaltet,

   d) einem Tiefpaß (TP), der die Impulse mit konstantem Flächeninhalt in eine Gleichspannung ($U_A$) zurückwandelt,

   e) einem Vergleicher (VG) der aus der Gleichspannung ($U_A'$) am Ausgang des Tiefpasses (TP) und aus der Eingangsspannung ($U_E$) des spannungsgesteuerten Oszillators (VCO) eine Differenzspannung ($U_{dE}$) bildet,

   f) einem Regler ($R_I$), der die Differenzspannung ($U_{dE}$) regelt und dessen Ausgangssignal ($U_R$) dem spannungsgesteuerten Oszillator (VCO) zugeführt wird.

FIG 1

FIG 2

FIG 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | DE-A-3617936 (ENDRESS U. HAUSER GMBH & CO.)<br>* Figuren 1,2; Spalte 3, Zeile 46 - Spalte 6, Zeile 32 * | 1 | G01R19/252<br>H03M1/60<br>H03K7/06<br>H02P7/00 |
| A | ELEKTRONIK<br>Band 34, Nr. 24, November 1985, Seiten 109-115, München, DE; J. WILLIAMS: "Ausgefeilte Spannungs/Frequenz-Wandler"<br>* Bild 9; Abschnitt: Ultralinearer U/f-Wandler * | 1 | |
| A | US-A-4698577 (R.S. SEYMOUR et al.)<br>* Figur 1 * | | |
| E | EP-A-0387686 (SIEMENS AG)<br>* Anspruch 4; Figur 2 * | 2 | **RECHERCHIERTE SACHGEBIETE (Int. Cl.5)**<br><br>G01R19/252<br>G08C19/26<br>H02P7/00<br>H03K7/06<br>H03M1/10<br>H03M1/60 |

Der vorliegende Recherchenbericht wurde für alle Patentansprüche erstellt

| Recherchenort | Abschlußdatum der Recherche | Prüfer |
|---|---|---|
| Berlin | 15.05.1991 | M. ARENDT |

Europäisches
Patentamt

---

## GEBÜHRENPFLICHTIGE PATENTANSPRÜCHE

Die vorliegende europäische Patentanmeldung enthielt bei ihrer Einreichung mehr als zehn Patentansprüche.

☐ Alle Anspruchsgebühren wurden innerhalb der vorgeschriebenen Frist entrichtet. Der vorliegende europäische Recherchenbericht wurde für alle Patentansprüche erstellt.

☐ Nur ein Teil der Anspruchsgebühren wurde innerhalb der vorgeschriebenen Frist entrichtet. Der vorliegende europäische Recherchenbericht wu de für die ersten zehn sowie für jene Patentansprüche erstellt für die Anspruchsgebühren entrichtet wurden.

nämlich Patentansprüche:

☐ Keine der Anspruchsgebühren wurde innerhalb der vorgeschriebenen Frist entrichtet. Der vorliegende europäische Recherchenbericht wurde für die ersten zehn Patentansprüche erstellt.

---

## x | MANGELNDE EINHEITLICHKEIT DER ERFINDUNG

Nach Auffassung der Recherchenabteilung entspricht die vorliegende europäische Patentanmeldung nicht den Anforderungen an die Einheitlichkeit der Erfindung; sie enthält mehrere Erfindungen oder Gruppen von Erfindungen, nämlich:

1. Patentanspruch 1:
   Verfahren zur Bestimmung der Frequenzverstärkung
   eines Spannungs-Frequenz-Wandlers

2. Patentanspruch 2:
   Regelkreis zur Regelung eines integrierenden
   spannungsgesteuerten Oszillators (VCO)

☒ A le weiteren Recherchengebühren wurden innerhalb der gesetzten Frist entrichtet. Der vorliegende europäische Recherchenbericht wurde für alle Patentansprüche erstellt.

☐ Nur ein Teil der weiteren Recherchengebühren wurde innerhalb der gesetzten Frist entrichtet. Der vorl egende europäische Recherchenbericht wurde für die Teile der Anmeldung erstellt die sich auf Erfindungen beziehen. für die Recherchengebühren entrichtet worden sind.

nämlich Patentansprüche:

☐ Ke ne der weiteren Recherchengebühren wurde innerhalb der gesetzten Frist entrichtet. Der vorliegende europäische Recherchenbericht wurde für die Teile der Anmeldung erstellt. die sich auf die zuerst in den Patent ansprüchen erwähnte Erfindung beziehen.

nam ch Patentansprüche: